# EUROPEAN PATENT SPECIFICATION

(11) **EP 4 603 446 B1**
(45) Date of publication and mention of the grant of the patent: **28.10.2026**
(21) Application number: 24158101.6
(22) Date of filing: 16.02.2024
(51) Int. Cl.: B81C 1/00, C03B 23/035, G02B 26/08

(54) **GLASS COVER MANUFACTURING USING A SINGLE-CRYSTAL SILICON MOLD**
HERSTELLUNG EINER GLASABDECKUNG UNTER VERWENDUNG EINER EINKRISTALLINEN SILIZIUMFORM
FABRICATION D'UN COUVERCLE EN VERRE UTILISANT UN MOULE EN SILICIUM MONOCRISTALLIN

(43) Date of publication of application: 20.08.2025
(73) Proprietor: Murata Manufacturing Co., Ltd., Nagaokakyo-shi, Kyoto 617-8555 (JP)
(72) Inventor: RUOHIO, Jaakko, 00100 Helsinki (FI); BLOMQVIST, Anssi, 00980 Helsinki (FI); KAUTTO, Mikael, 00270 Helsinki (FI)
(74) Representative: Boco IP Oy Ab

(56) References cited:
- US-A1- 2015 200 105

## Description

### FIELD OF THE DISCLOSURE

The present disclosure relates to a method of manufacturing a transparent cover, and particularly to a method of manufacturing a transparent glass cover with angled optical window suitable to be used to protect a MEMS device such as a MEMS mirror.

### BACKGROUND OF THE DISCLOSURE

One possible method of producing an image in augmented reality (AR) glasses, virtual reality (VR) glasses and heads-up displays is by scanning a light beam utilizing a tilting mirror system. A very small tilting mirror for such purpose may be manufactured using microelectromechanical system (MEMS) technology.

Packaging the mirror system into a hermetic enclosure enables low-loss operation of the tilting mirror, in other words, a high-quality factor. For example, gases may be reduced or removed from the hermetic enclosure would cause mechanical losses for the fast-moving mirror.

A package of a MEMS mirror should preferably comprise a transparent cover. When using a dual axis tilting mirror, reflection of the light beam from the interface or interfaces of the transparent cover and the ambient and/or hermetic atmosphere results in a bright spot. When using two single axis tilting mirror, and reflection of the light beam from the interface or interfaces of the transparent cover and the ambient and/or hermetic atmosphere results in a bright line. Utilizing an angled cover in the hermetic package is a known solution to prevent such bright line or spot coinciding within the intended image area.

Document US 8517545 discloses a cover for microsystems and method for producing a cover, in which an angled optical window, mirror or partially reflecting mirror made of glass is used to avoid bright spots. Silicon is used as reinforcing elements in the regions of the glass wafer that function as angled optical windows, while glass sheet is deformed so that reinforced portions are inclined. However, such reinforcing elements are difficult to manufacture and add cost, and controlling the inclination is difficult.

Patent application publication US 2015/200105 A1 discloses a production method for manufacturing a micromirror with a cover layer having an exposed window region where the window is formed by heat-softening a glass film so that it is moulded into recesses etched in a silicon wafer. After cooling and solidification of the glass cover structures, regions of the mould are etched away to reveal the final window structures which are then directly bonded to devices on a substrate to form the final optical packages. Parts of the mould layer remain with the windows in the form of a protecting frame.

Silicon wafers are grown starting from a crystal seed having a regular crystal structure, with silicon having a diamond cubic structure with a constant lattice spacing. When silicon is cut into wafers, the surface of the wafer is aligned in one of several directions with respect to the crystal structure, known as crystal orientations. This crystal orientation is defined by a Miller index. Most common Miller indexes for silicon wafers are <100> and <111>, but also <110> is occasionally used. In each of these cases, the silicon is cut in a crystal orientation. However, silicon wafers may also be cut in an off-crystal orientation. Surfaces of these different crystal orientations may alternatively be referred to with notations Si(100), Si(110), and Si(111). Crystal orientation is important since many of a single crystal's structural and electronic properties are highly anisotropic. Ion implantation depths depend on the wafer's crystal orientation since each direction offers distinct paths for transport.

A problem is to enable manufacturing of at least one angled optical window in an optical glass cover in simple and cost-effective manufacturing process, while ensuring high quality of the at least one angled optical window in the optical glass cover.

### SUMMARY OF THE INVENTION

A method according to the invention is given by claim 1. In the remainder of this description all references to objects, aspects and embodiments refer to examples which are given to help in understanding the invention.

### BRIEF DESCRIPTION OF THE DISCLOSURE

An object of the present disclosure is to provide a manufacturing method (and an optical glass cover with at least one angled optical window) so as to solve the above problem.

The object of the disclosure is achieved by a manufacturing method and an optical glass cover which are characterized by what is stated in the independent claims. Some embodiments of the disclosure are disclosed in the dependent claims.

The disclosure is based on the idea of using a single-crystal silicon mold for shaping an optical glass cover with one or more angled optical windows.

According to a first aspect, a method of manufacturing a plurality of devices having an optical glass cover comprising an angled optical window is provided. The method comprises patterning a face of an off-axis cut silicon wafer to determine a plurality of unmasked areas of the off-axis cut silicon wafer, wet-etching the plurality of unmasked areas to reveal respective a plurality of Si(111) surfaces of the off-axis cut silicon wafer, to form a silicon mold comprising a plurality of angled recesses, wherein an angled shape of each angled recess is determined by a Si(111) surface, molding borosilicate glass using the silicon mold to form a plurality of angled glass portions, cooling the molded borosilicate glass, optionally grinding the molded borosilicate glass, polishing the cooled and optionally grinded borosilicate glass, anodically bonding the polished borosilicate glass to a silicon device wafer comprising a plurality of structures and/or circuitry for the plurality of devices, removing the silicon mold by etching to release a wafer stack with borosilicate glass and the silicon device wafer, and dicing the wafer stack to separate the plurality of devices having the optical glass cover, wherein the optical glass cover of each device comprises the respective angled optical window determined by one of the angled recesses of the silicon mold.

According to some embodiments, quality of the plurality of Si(111) surfaces revealed by the wet-etching is further improved by hydrogen (H2) and/or acid treatment.

According to some embodiments, the silicon mold is removed by etching.

According to some embodiments, the step of molding borosilicate glass using the silicon mold comprises applying a sheet of borosilicate glass on the silicon mold in vacuum to hermetically seal the plurality of angled recesses in the silicon mold, and a) heating up the sheet of borosilicate glass, and applying an inert pressure to cause the heated sheet of borosilicate glass to adapt to the shape of the silicon mold, or b) heating up the sheet of borosilicate glass into a temperature above its Littleton Softening Point and allowing the heated sheet of borosilicate glass to adapt to the shape of the silicon mold under its own weight.

According to some embodiments, thickness of the sheet or the layer of the borosilicate glass is less than a greatest vertical distance from non-etched portions of the patterned face of the silicon mold to the bottom of the recess formed by the angled portion of the silicon mold.

According to some embodiments, thickness of the sheet or the layer of borosilicate glass is between 50 µm and 500 µm.

According to some embodiments, the step of molding borosilicate glass using the silicon mold comprises molding a layer of heat-softened borosilicate glass on the silicon mold, and grinding the molded layer of borosilicate glass after the step of cooling and before the step of polishing.

According to some embodiments, thickness of the layer of borosilicate glass is more than a greatest vertical distance from non-etched portions of the patterned face of the silicon mold to the bottom of the recess formed by the angled portion of the silicon mold.

According to some embodiments, thickness of the layer of borosilicate glass is between 200 µm and 1000 µm.

According to some embodiments, a cut angle of the off-axis cut silicon wafer is in a range from 5° to 25°, preferably about 20° off with respect to the Si(111) crystal orientation, and the tilt angle of the angled optical window is equal to the cut angle of the off-axis cut silicon wafer.

According to some embodiments, the plurality of structures and/or devices comprise a plurality of MEMS devices.

According to some embodiments, the plurality of structures and/or devices comprise a plurality of MEMS mirrors, and wherein the cut angle of the off-axis cut silicon wafer is greater than maximum tilt angle of the respective MEMS mirror.

According to a second aspect, a MEMS mirror is provided that is manufactured using the method according to any one of the first aspect and its embodiment.

According to a third aspect, pair of augmented reality (AR) glasses, a pair of virtual reality (VR) glasses or a heads-up display comprising at least one MEMS mirror according to the second aspect.

An advantage of the manufacturing method of the disclosure is that the manufacturing method is straightforward and cost effective, and the resulting angled optical windows have well-defined tilting angles.

### BRIEF DESCRIPTION OF THE DRAWINGS

In the following the disclosure will be described in greater detail by means of preferred embodiments with reference to the accompanying drawings, in which:
Figure 1 illustrates a silicon crystal and a Si(111) crystal orientation;
Figure 2 illustrates cutting of silicon wafers in an off-crystal orientation;
Figures 3A to 3F illustrate manufacturing steps of an optical glass cover of a MEMS mirror according to some embodiments.
Figures 4A to 4G illustrate schematically manufacturing steps of a MEMS mirror device according to some embodiments.
Figured 5A and 5B illustrate schematically MEMS mirror devices with angled optical glass covers.

The figures are for illustrative purposes only and are not shown in scale.

### DETAILED DESCRIPTION OF THE DISCLOSURE

The present disclosure relates to a method of manufacturing a transparent cover, in particular a transparent glass cover with an angled optical window, and particularly to a method of manufacturing a transparent glass cover with angled optical window suitable to be used to protect a MEMS device such as a MEMS mirror. The present disclosure further concerns a MEMS mirror device with an angled optical window.

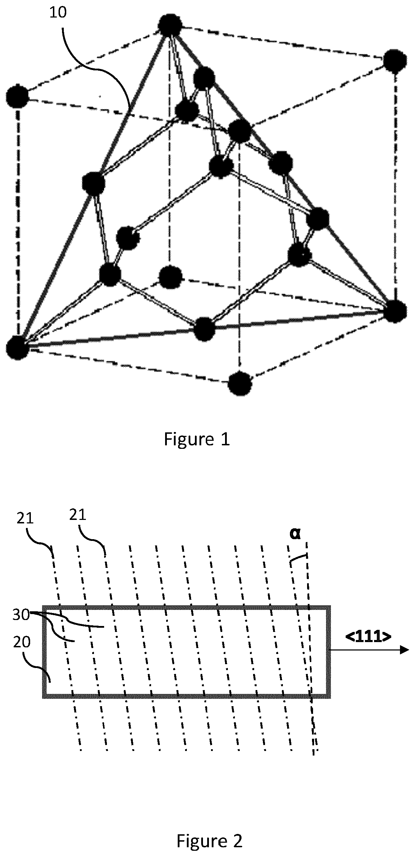

Figure 1 illustrates a silicon crystal with a plurality of silicon atoms in a crystal lattice. Crystal orientation referred to as Si(111) is illustrated with the triangular shape marked with a bold line 10.

Figure 2 illustrates generation of off-axis cut silicon wafers. High-purity silicon crystalline material may be formed using a so called Czochralski method, in which a cylindrical boule 20 is formed by pulling a seed crystal from a melt. The generated boule 20 shown in this side view, has a predetermined crystal orientation. The arrow <111> illustrates normal of the <111> orientation. For generating off-axis cut silicon wafers, boule 20 is cut into a plurality of off-axis cut silicon wafers 30 in a predetermined cut angle α with respect to the <111> orientation, as illustrated with the plurality of mutually parallel dashed lines 21. In the field of the disclosure, the optimal cut angle depends on optical requirements set by the device for which the optical window is manufactured. The cut angle is preferably bigger than the maximum tilting angle of the MEMS mirror. In this example, the cut angle α is within the range from 15° to 25°, preferably about 20°. For some applications, the cut angle α may be selected within a range from 5° to 25°. For the disclosed manufacturing method, the off-axis cut silicon wafer is preferably not doped.

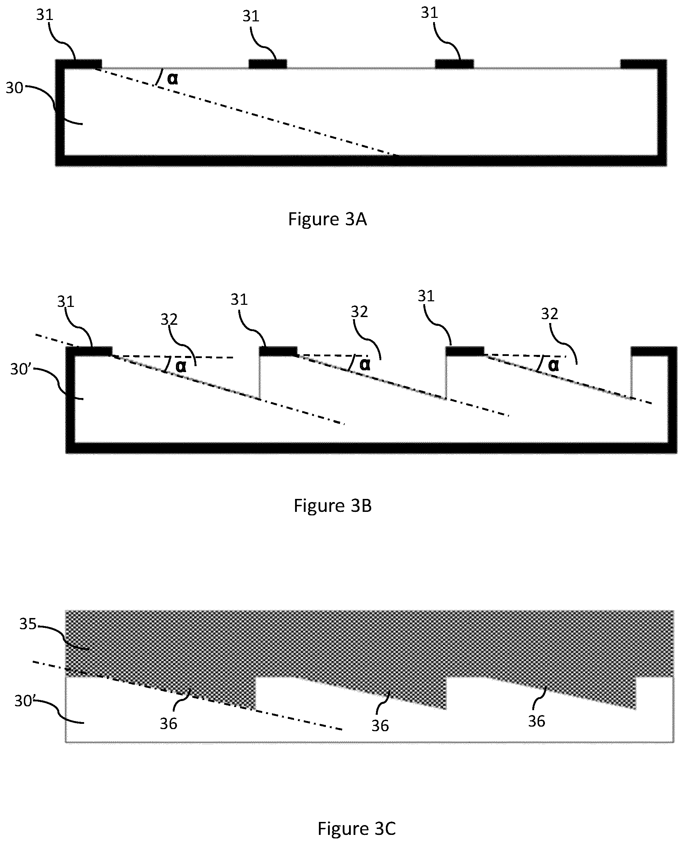

Figures 3A to 3F illustrate manufacturing steps of an optical glass cover of a MEMS mirror according to some embodiments. The optical glass cover comprises an angled optical window.

Figure 3A illustrates an off-axis cut silicon wafer 30, that is masked with a mask 31. The masking pattern comprises a plurality of unmasked areas, which leave desired portions of the off-axis cut silicon wafer 30 exposed. Any applicable masking method may be used. For example, a silicon nitride mask may be patterned using a photoresist mask and plasma etching.

As illustrated by the Figure 3B, the masked off-axis cut silicon wafer 30 is wet-etched to reveal a plurality of Si(111) surfaces of the off-axis cut silicon wafer, to form a silicon mold 30' comprising a plurality of angled recesses each determined a Si(111) surface. The cut angle α of the off-axis silicon wafer 30 is equal to the tilt angle α of the angled recesses in the silicon mold 30'. One suitable wet-etching method to be used for this step is potassium hydroxide (KOH) etching, which is well-known to etch silicon crystals anisotropically. An anisotropic etch means that etch rate is different for different Si crystal planes.

The quality of the plurality of Si(111) surfaces revealed by the wet-etching may further be improved by hydrogen (H2) and/or acid treatment.

After forming the silicon mold 30' by etching, the mask 31 is removed. If the exemplary nitride mask is used, the mask 31 may be removed by etching. The result is a silicon mold 30' with a plurality of angled recesses 32, each having the tilt angle α determined by the cut angle α of the off-axis cut silicon wafer.

Figure 3C illustrates the next step, in which a layer of borosilicate glass 35 is molded. A layer of borosilicate glass 35 is applied on the silicon mold 30' and softened by heating it so that the heated layer of borosilicate class 35 becomes molded by the silicon mold 30', the borosilicate glass filling the angled recesses 32 forms a plurality of angled glass portions 36 in the molded layer of borosilicate glass 35. According to some embodiments, the layer of borosilicate glass may be heated into a temperature at or above its Littleton Softening Point, which enables the heated layer of borosilicate glass to adapt to the shape of the silicon mold 30' under its own weight. According to some embodiments, inert pressure may be applied on the softened layer of borosilicate glass 35 such that it fills the angled recesses 32. In the latter alternative, it is not necessary to heat up the layer of borosilicate glass 35 to or above the Littleton Softening Point temperature, but it is enough that it is heated into a temperature that makes it moldable.

In this example, thickness of the layer of borosilicate glass 35 is more than the greatest depth of the angled recesses 32 in the silicon mold 30', so that the patterned face of the silicon mold 30' is fully covered by the layer of borosilicate glass 35.

After the molded layer of borosilicate glass has cooled and hardened, it is ground to remove excess thickness of the borosilicate glass layer, optionally further polished to generate and/or improve a flat outer face of the molded borosilicate glass layer. Preferably, cooling of the borosilicate glass is performed using a controlled temperature ramp to ensure high quality of the hardened, molded borosilicate glass layer. The borosilicate glass is now readily formed as the optical glass cover 50 that comprises a plurality of angled optical windows.

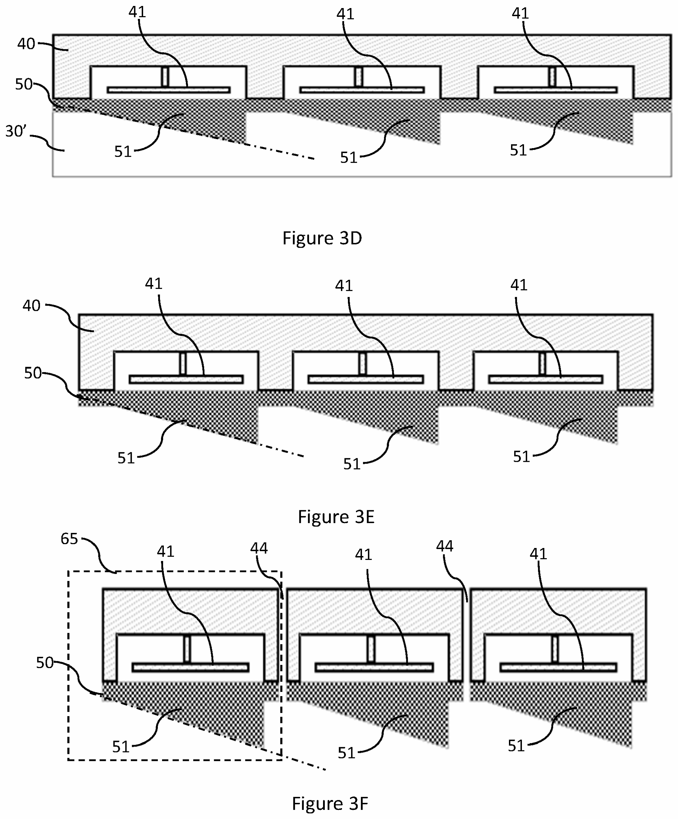

Figure 3D illustrates the next step, in which the outer face of the borosilicate glass layer is anodically bonded to a MEMS wafer 40 comprising a plurality of MEMS mirrors 41. Details of manufacturing the MEMS wafer 40 are not in the scope of this disclosure. The optical glass cover 50 that comprises a plurality of angled optical windows 51 is protected by the silicon mold 30' during the bonding step.

Figure 3E illustrates the next step, in which the silicon mold 30' is removed by etching. This etching may be performed for example by using ethylene diamine pyrocatechol (EDP) etching or by reactive-ion etching (RIE), which effectively removes the silicon, but do not harm the borosilicate glass. Optionally, a layer of suitable material, for example gold or chrome deposited on top of the silicon mold wafer improves selectivity and reduces potential damage. Optical glass cover 50 now forms a plurality of angled optical windows 51.

In this embodiment, only the exposed face of the angled optical windows 51 is angled, while the non-exposed face of the optical glass cover 50 that is towards the plurality of MEMS mirrors 41 is not angled, but forms a flat plane.

Figure 3F illustrates step of dicing 44 the MEMS wafer provided with the optical glass cover to separate the plurality of MEMS mirror devices 65. Each MEMS mirror device comprises a respective angled optical window formed in the borosilicate glass as determined by one of the angled recesses 32 of the silicon mold 30'.

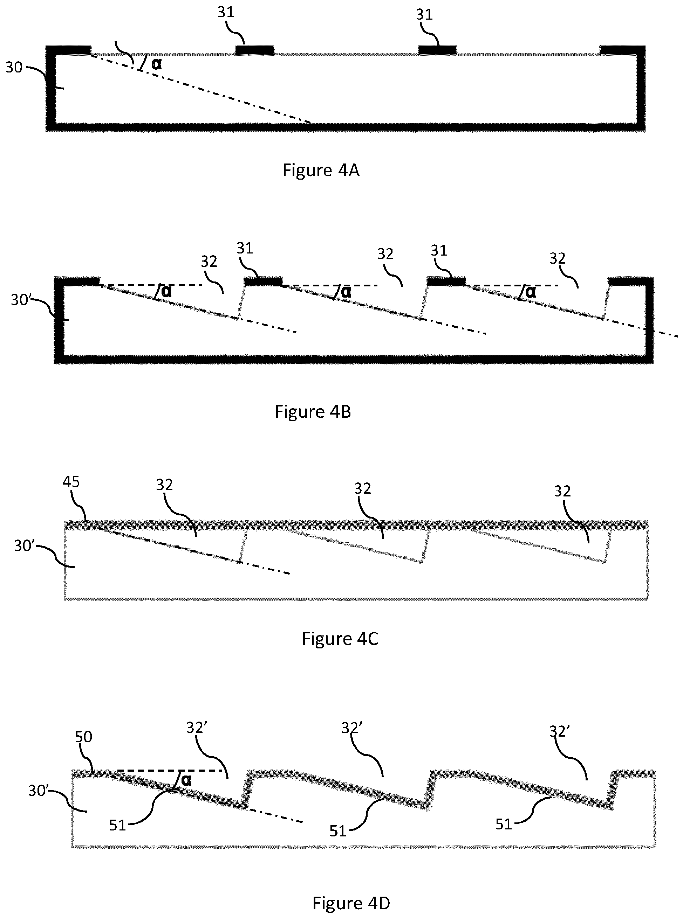

Figures 4A to 4G illustrate manufacturing steps of an optical glass cover of a MEMS mirror according to some embodiments. The optical glass cover comprises an angled optical window.

Figure 4A illustrates an off-axis cut silicon wafer 30, that is masked with a mask 31. The masking pattern comprises a plurality of unmasked areas, which leave desired portions of the off-axis cut silicon wafer 30 exposed. Any applicable masking method may be used. For example, a silicon nitride mask may be patterned using photoresist mask and etched with plasma.

As illustrated by the Figure 4B, the masked off-axis cut silicon wafer 30 is wet-etched to reveal a plurality of Si(111) surfaces of the off-axis cut silicon wafer, to form a silicon mold 30' comprising a plurality of angled recesses each determined a Si(111) surface. The cut angle α of the off-axis silicon wafer 30 is equal to the tilt angle α of the angled recesses in the silicon mold 30'. One suitable wet-etching method to be used for this step is potassium hydroxide (KOH) etching, which is well-known to etch silicon crystals anisotropically.

The quality of the plurality of Si(111) surfaces revealed by the wet-etching may further be improved by hydrogen (H2) and/or acid treatment.

After forming the silicon mold 30' by etching, the mask 31 is removed. If the exemplary silicon nitride mask is used, the mask 31 may be removed by etching. The result is a silicon mold 30' with a plurality of angled recesses 32 on one face of the silicon mold 30', each angled recess 32 having the tilt angle α determined by the cut angle α of the off-axis cut silicon wafer.

Next, a sheet of borosilicate glass 45 is molded using the silicon mold 30'.

Figure 4C illustrates a step in which the initially flat sheet of borosilicate glass 45 is first applied in vacuum on the patterned face of the silicon mold 30' to hermetically seal the plurality of angled recesses 32 in the silicon mold 30' with the sheet of borosilicate glass 45. The sheet of borosilicate glass is then heated in vacuum to soften it, so that it becomes moldable. These steps are performed in vacuum to ensure that no gas remains in the angled recesses 32 between the silicon mold 30' and the sheet of borosilicate glass 45, which would reduce quality of the eventually molded borosilicate glass and thus quality the optical cover. As known in the art, heating temperature of borosilicate glass depends heavily on type of glass and exact process as well as desired viscosity of the glass.

After hermetically sealing the angled recesses 32 with the initially flat, heated sheet of borosilicate glass 45, inert pressure may be applied to cause the heated sheet of borosilicate glass 45 to adapt to the shape of the silicon mold 30', thus pressing the initially flat sheet of borosilicate glass 45 into the angled recesses 32 of the silicon mold 30' to shape the sheet of borosilicate glass 45 into the desired shape of the optical glass cover 50 now forming the plurality of angled optical windows 51. Alternatively, the sheet of borosilicate glass 45 may be heated into a temperature above its Littleton Softening Point, which enables the heated sheet of borosilicate glass 45 to adapt to the shape of the silicon mold 30' under its own weight, so that application of inert pressure is not required. However, inert pressure may be applied even when the sheet of borosilicate glass is heated in a temperature at or above its Littleton Softening Point for speeding up the shape adaptation step.

The readily molded sheet of borosilicate glass is then cooled to harden it. Preferably, cooling of the borosilicate glass is performed using a controlled temperature ramp to ensure high quality of the hardened glass. After the molded sheet of borosilicate glass has cooled and hardened, it is optionally polished to further improve quality of the angled optical windows 51.

To achieve the desired shape with good quality, thickness of the sheet of borosilicate glass 45 should be less than the greatest depth of the angled recesses 32 in the silicon mold 30', so that upper face of the optical glass cover 50 formed by the molded sheet of borosilicate glass 45 comprises angled recesses 32' in the upper face angled optical windows 51.

According to an exemplary manufacturing process, maximum depth of the angled recesses 32 measured from the outer surface of the patterned face of the silicon mold 30' depends on dimensions of the patterned areas on the silicon mold 30' and the cut angle α. For example a recess 32 generated into the silicon mold 30' with a α =15° and a 0.5 mm wide opening in the mask 31 is tan (15°)*0.5 mm = 0.13 mm and a recess 32 generated into a silicon mold 30' with a α=25° and a 5 mm wide opening in the mask 31 is tan(25°)*15mm=2.3 mm. Thickness of the sheet of borosilicate glass 45 is between 50 µm and 500 µm, preferably between 100 µm and 400 µm, more preferably between 150 µm and 300 µm, most preferably about 200 µm.

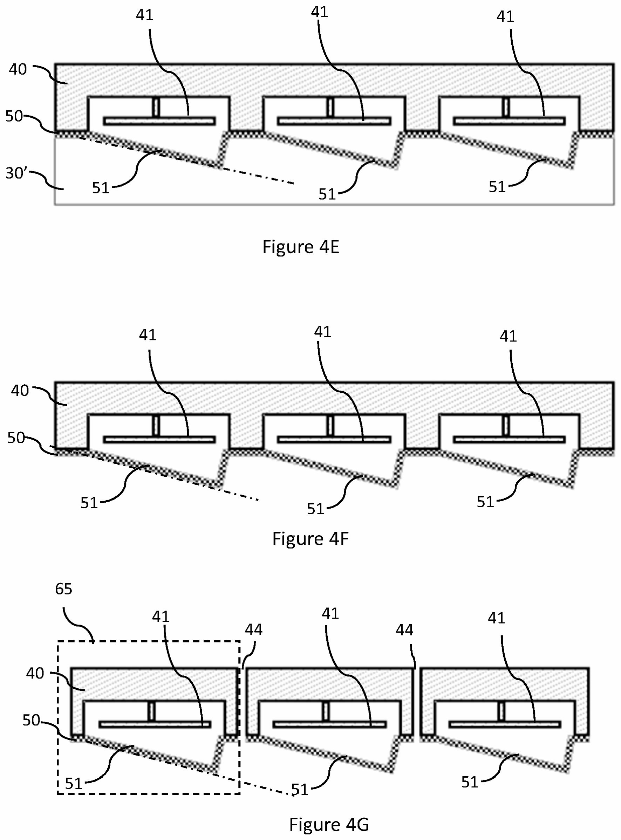

Figure 4E illustrates the next step, in which the optionally polished borosilicate glass layer is anodically bonded to a MEMS wafer 40 comprising a plurality of MEMS mirrors 41. Details of manufacturing the MEMS wafer 40 are not in the scope of this disclosure.

Figure 4F illustrates the next step, in which the silicon mold 30' is removed by etching. This etching may be performed for example using ethylene diamine pyrocatechol (EDP) etching or by reactive-ion etching (RIE), which effectively removes the silicon, but does not harm the borosilicate glass.

Figure 4G illustrates step of dicing 44 the MEMS wafer provided with the optical glass cover to separate the plurality of MEMS mirror devices 65. Each MEMS mirror device 65 comprises a respective angled optical window formed in the borosilicate glass as determined by one of the angled recesses 32 of the silicon mold 30'.

As known in the art, diced MEMS mirror devices 65 received as results of step 3F or 4G are typically further provided with external electrical connections. However, details of implementing such additional features of the MEMS or other applicable devices are not in scope of this disclosure.

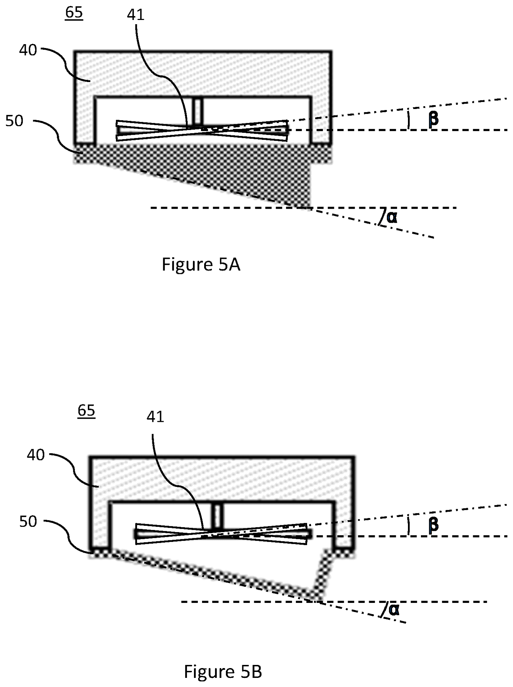

Figure 5A illustrates a single MEMS mirror device 65 implemented with the optical glass cover comprising an angled optical window according to the first embodiment. Figure 5B illustrates a single MEMS mirror device 65 implemented with the optical glass cover comprising an angled optical window according to the first embodiment. Tilt angle α of the angled optical window and thus also the cut angle of the off-axis cut silicon wafer should be more than the maximum tilt angle β of the MEMS mirror to avoid bright spots being generated due to the angled optical window, which could occur if the angled optical window and the MEMS mirror were parallel at any applied tilting angle of the MEMS mirror.

Depending on the manufacturer's process technologies, the manufacturing process of the first embodiment is likely easier to implement than manufacturing process of the second embodiment. A possible technical drawback of the first embodiment is that the inner surface of the angled optical window is not angled, which may cause a lower intensity bright spot in the field of view. The second embodiment has all surfaces of the angled optical window angled, thus provides a higher quality solution but may be more difficult and expensive to manufacture. The thinner angled optical window according to the second embodiment may be less tolerant to mechanical impacts than the thicker optical window according to the first embodiment. Selection of preferred embodiment thus depends at least on requirements of optical quality and robustness of the device.

Although the method of the invention has been explained using a MEMS mirror device as a non-limiting example, the invention is not limited to MEMS mirror devices, but is applicable to any type of silicon-based devices comprising circuitry and/or structures that are manufactured by processing a silicon wafer and need an angled optical window for covering the silicon device and protecting at least some parts of the silicon device from ambient environment with an angled optical window.

## Claims

1. A method of manufacturing a plurality of devices having an optical glass cover comprising an angled optical window, wherein the method comprises, in order of completion:
- patterning a face of an off-axis cut silicon wafer (30) to determine a plurality of unmasked areas of the off-axis cut silicon wafer (30),
- wet-etching the plurality of unmasked areas to reveal respective a plurality of Si(111) surfaces of the off-axis cut silicon wafer, to form a silicon mold (30') comprising a plurality of angled recesses (32), wherein an angled shape of each angled recess (32) is determined by a Si(111) surface,
- molding heat-softened borosilicate glass (35, 45) using the silicon mold (30') to form a plurality of angled glass portions (36, 51),
- cooling the molded borosilicate glass (50),
- optionally grinding the molded borosilicate glass (50),
- polishing the cooled and optionally grinded borosilicate glass (50),
- anodically bonding the polished borosilicate glass (50) to a silicon device wafer (40) comprising a plurality of structures and/or circuitry for the plurality of devices, and
- dicing the wafer stack to separate the plurality of devices (45) having the optical glass cover, wherein the optical glass cover of each device comprises the respective angled optical window (36, 51) determined by one of the angled recesses (32) of the silicon mold (30'),
wherein after the step of anodically bonding and before the step of dicing the wafer stack, the method comprises:
- removing the silicon mold (30') by etching to release a wafer stack with the borosilicate glass (50) and the silicon device (40).

2. The method of manufacturing according to claim 1, wherein quality of the plurality of Si(111) surfaces revealed by the wet-etching is further improved by hydrogen (H₂) and/or acid treatment.

3. The method of manufacturing according to claim 1 or 2, wherein the silicon mold is removed by ethylene diamine pyrocatechol (EDP) etching or by reactive-ion etching (RIE).

4. The method according to any one of claims 1 to 3, wherein the step of molding borosilicate glass (45) using the silicon mold (30') comprises:
- applying a sheet of borosilicate glass (45) on the silicon mold (30') in vacuum to hermetically seal the plurality of angled recesses (32) in the silicon mold (30'), and
a) heating up the sheet of borosilicate glass (45), and applying an inert pressure to cause the heated sheet of borosilicate glass to adapt to the shape of the silicon mold (30'), or
b) heating up the sheet of borosilicate glass (45) into a temperature above its Littleton Softening Point and allowing the heated sheet of borosilicate glass to adapt to the shape of the silicon mold (30') under its own weight.

5. The method according to claim 4, wherein thickness of the sheet or the layer of borosilicate glass (45) is less than a greatest vertical distance from non-etched portions of the patterned face of the silicon mold (30') to the bottom of the recess (32) formed by the angled portion of the silicon mold (30').

6. The method according to claim 5, wherein thickness of the sheet (45) or the layer (35) of borosilicate glass is between 50 µm and 500 µm.

7. The method according to any one of claims 1 to 3, wherein the step of molding borosilicate glass (45) using the silicon mold (30') comprises:
- molding a layer of heat-softened borosilicate glass (35) on the silicon mold (30'), and
- grinding the molded layer of borosilicate glass (35) after the step of cooling and before the step of polishing.

8. The method according to claim 6, wherein thickness of the layer of borosilicate glass (35) is more than a greatest vertical distance from non-etched portions of the patterned face of the silicon mold (30') to the bottom of the recess (32) formed by the angled portion of the silicon mold (30').

9. The method according to claim 7, wherein thickness of the layer of borosilicate glass (35) is between 200 µm and 1000 µm.

10. The method according to any one of claims 1 to 8, wherein a cut angle (α) of the off-axis cut silicon wafer (30) is in a range from 5° to 25°, preferably about 20° off with respect to the Si(111) crystal orientation, and the tilt angle (β) of the angled optical window is equal to the cut angle (α) of the off-axis cut silicon wafer.

11. The method according to any one of claims 1 to 9, wherein the plurality of structures and/or devices comprise a plurality of MEMS devices (65).

12. The method according to any one of claims 1 to 9, wherein the plurality of structures and/or devices comprise a plurality of MEMS mirrors (41), and wherein the cut angle (α) of the off-axis cut silicon wafer (30) is greater than maximum tilt angle (β) of the respective MEMS mirror (41).

## Patentansprüche

1. Verfahren zur Herstellung von mehreren Bauelementen mit einer optischen Glasabdeckung, die ein abgewinkeltes optisches Fenster umfasst, wobei das Verfahren folgende Schritte in der Reihenfolge der Ausführung umfasst:
- Strukturieren einer Fläche eines außerachsig geschnittenen Siliciumwafers (30), um mehrere unmaskierte Bereiche des außerachsig geschnittenen Siliciumwafers (30) zu bestimmen,
- Nassätzen der mehreren unmaskierten Bereiche, um entsprechend mehrere Si(111)-Oberflächen des außerachsig geschnittenen Siliciumwafers freizulegen, zur Ausbildung einer Siliciumform (30'), die mehrere abgewinkelte Vertiefungen (32) umfasst, wobei eine abgewinkelte Form jeder abgewinkelten Vertiefung (32) durch eine Si(111)-Oberfläche bestimmt wird,
- Formen von thermisch erweichtem Borosilikatglas (35, 45) mit Hilfe der Siliciumform (30'), um mehrere abgewinkelte Glasabschnitte (36, 51) auszubilden,
- Abkühlen des geformten Borosilikatglases (50),
- wahlweise Schleifen des geformten Borosilikatglases (50),
- Polieren des abgekühlten und wahlweise geschliffenen Borosilikatglases (50),
- anodisches Bonden des polierten Borosilikatglases (50) mit einem Silicium-Bauelementwafer (40), der mehrere Strukturen und/oder eine Schaltungsanordnung für die mehreren Bauelemente umfasst, und
- Vereinzeln des Waferstapels, um die mehreren Bauelemente (45) mit der optischen Glasabdeckung zu trennen, wobei die optische Glasabdeckung jedes Bauelements das jeweilige, durch eine der abgewinkelten Vertiefungen (32) der Siliciumform (30') bestimmte abgewinkelte optische Fenster (36, 51) umfasst,
wobei nach dem Schritt des anodischen Bondens und vor dem Schritt der Vereinzelung des Waferstapels das Verfahren umfasst:
- Entfernen der Siliciumform (30') durch Ätzen, um einen Waferstapel mit dem Borosilikatglas (50) und dem Silicium-Bauelement (40) freizusetzen.

2. Verfahren zur Herstellung nach Anspruch 1, wobei die Güte der mehreren durch das Nassätzen freigelegten Si(111)-Oberflächen durch eine Behandlung mit Wasserstoff (H₂) und/oder Säurebehandlung weiter verbessert wird.

3. Verfahren zur Herstellung nach Anspruch 1 oder 2, wobei die Siliciumform durch Ätzen mit Ethylendiaminpyrocatechol (EDP) oder durch reaktives Ionenätzen (RIE) entfernt wird.

4. Verfahren nach einem der Ansprüche 1 bis 3, wobei der Schritt der Formung von Borosilikatglas (45) mit Hilfe der Siliciumform (30') umfasst:
- Aufbringen einer Scheibe von Borosilikatglas (45) auf die Siliciumform (30') im Vakuum, um die mehreren abgewinkelten Vertiefungen (32) in der Siliciumform (30') hermetisch abzudichten, und
a) Erwärmen der Scheibe von Borosilikatglas (45), und Anlegen eines inerten Drucks, um zu bewirken, dass sich die erwärmte Borosilikatglasscheibe an die Form der Siliciumform (30') anpasst, oder
b) Erwärmen der Scheibe von Borosilikatglas (45) auf eine Temperatur oberhalb ihres Littleton-Erweichungspunkts und Ermöglichen, dass sich die erwärmte Borosilikatglasscheibe unter ihrem Eigengewicht an die Form der Siliciumform (30') anpasst.

5. Verfahren nach Anspruch 4, wobei die Dicke der Scheibe oder Schicht von Borosilikatglas (45) kleiner ist als der größte vertikale Abstand von den nicht geätzten Bereichen der strukturierten Fläche der Siliciumform (30') bis zum Grund der durch den abgewinkelten Abschnitt der Siliciumform (30') ausgebildeten Vertiefung (32).

6. Verfahren nach Anspruch 5, wobei die Dicke der Scheibe (45) oder der Schicht (35) von Borosilikatglas zwischen 50 µm und 500 µm beträgt.

7. Verfahren nach einem der Ansprüche 1 bis 3, wobei der Schritt der Formung von Borosilikatglas (45) mit Hilfe der Siliciumform (30') umfasst:
- Formen einer Schicht von thermisch erweichtem Borosilikatglas (35) auf der Siliciumform (30'), und
- Schleifen der geformten Schicht von Borosilikatglas (35) nach dem Schritt des Abkühlens und vor dem Schritt des Polierens.

8. Verfahren nach Anspruch 6, wobei die Dicke der Schicht von Borosilikatglas (35) größer ist als der größte vertikale Abstand von den nicht geätzten Bereichen der strukturierten Fläche der Siliciumform (30') bis zum Grund der durch den abgewinkelten Abschnitt der Siliciumform (30') ausgebildeten Vertiefung (32).

9. Verfahren nach Anspruch 7, wobei die Dicke der Schicht von Borosilikatglas (35) zwischen 200 µm und 1000 µm beträgt.

10. Verfahren nach einem der Ansprüche 1 bis 8, wobei ein Schnittwinkel (α) des außerachsig geschnittenen Siliciumwafers (30) in einem Bereich von 5° bis 25°, bevorzugt bei etwa 20° in Bezug auf die Si(111)-Kristallorientierung liegt, und der Neigungswinkel (β) des abgewinkelten optischen Fensters gleich dem Schnittwinkel (α) des außerachsig geschnittenen Siliciumwafers ist.

11. Verfahren nach einem der Ansprüche 1 bis 9, wobei die mehreren Strukturen und/oder Bauelemente mehrere MEMS-Bauelemente (65) umfassen.

12. Verfahren nach einem der Ansprüche 1 bis 9, wobei die mehreren Strukturen und/oder Bauelemente mehrere MEMS-Spiegel (41) umfassen, und wobei der Schnittwinkel (α) des außerachsig geschnittenen Siliciumwafers (30) größer als ein maximaler Neigungswinkel (β) des jeweiligen MEMS-Spiegels (41) ist.

## Revendications

1. Procédé de fabrication de plusieurs dispositifs ayant un couvercle en verre optique comprenant une fenêtre optique inclinée, le procédé comprenant, dans l'ordre de réalisation, les étapes consistant à :
- structurer une face d'une tranche de silicium coupée hors-axe (30) afin de déterminer plusieurs zones non masquées de la tranche de silicium coupée hors-axe (30),
- graver par voie humide plusieurs zones non masquées pour mettre à nu respectivement plusieurs surfaces Si(111) de la tranche de silicium coupée hors axe, afin de former un moule en silicium (30') comprenant plusieurs évidements inclinés (32), une forme inclinée de chaque évidement incliné (32) étant déterminée par une surface Si(111),
- mouler du verre borosilicaté ramolli thermiquement (35, 45) au moyen du moule en silicium (30') afin de former plusieurs portions de verre inclinées (36, 51),
- refroidir le verre borosilicaté moulé (50),
- facultativement, meuler le verre borosilicaté moulé (50),
- polir le verre borosilicaté (50) refroidi et, facultativement, meulé,
- réaliser un bonding anodique du verre borosilicaté poli (50) avec une tranche de dispositif de silicium (40) comprenant plusieurs structures et/ou un ensemble de circuits pour les plusieurs dispositifs, et
- découper l'empilement de tranches afin de séparer les plusieurs dispositifs (45) ayant le couvercle en verre optique, le couvercle en verre optique de chaque dispositif comprenant la fenêtre optique inclinée respective (36, 51) déterminée par l'un des évidements inclinés (32) du moule en silicium (30'),
dans lequel, après l'étape de bonding anodique et avant l'étape de découpe de l'empilement de tranches, le procédé comprend l'étape consistant à :
- éliminer par gravure le moule en silicium (30') afin de libérer un empilement de tranches avec le verre borosilicaté (50) et le dispositif de silicium (40).

2. Procédé de fabrication selon la revendication 1, dans lequel la qualité des plusieurs surfaces Si(111) mises au jour par la gravure humide est améliorée davantage par un traitement à l'hydrogène (H2) et/ou un traitement acide.

3. Procédé de fabrication selon la revendication 1 ou 2, dans lequel le moule en silicium est éliminé par gravure à l'éthylènediamine-pyrocatéchol (EDP) ou par gravure ionique réactive (RIE).

4. Procédé selon l'une quelconque des revendications 1 à 3, dans lequel l'étape de moulage du verre borosilicaté (45) au moyen du moule en silicium (30') comprend les étapes consistant à :
- appliquer une feuille de verre borosilicaté (45) sur le moule en silicium (30') sous vide afin de sceller hermétiquement les plusieurs évidements inclinés (32) dans le moule en silicium (30'), et
a) chauffer la feuille de verre borosilicaté (45), et appliquer une pression inerte afin d'amener la feuille de verre borosilicaté chauffée à épouser la forme du moule en silicium (30'), ou
b) chauffer la feuille de verre borosilicaté (45) à une température au-dessus de son point de ramollissement Littleton et permettre à la feuille de verre borosilicaté chauffée d'épouser la forme du moule en silicium (30') sous son propre poids.

5. Procédé selon la revendication 4, dans lequel l'épaisseur de la feuille ou couche de verre borosilicaté (45) est inférieure à la distance verticale maximale entre les parties non gravées de la face structurée du moule en silicium (30') et le fond de l'évidement (32) formé par la portion inclinée du moule en silicium (30').

6. Procédé selon la revendication 5, dans lequel l'épaisseur de la feuille (45) ou de la couche (35) de verre borosilicaté est comprise entre 50 µm et 500 µm.

7. Procédé selon l'une quelconque des revendications 1 à 3, dans lequel l'étape de moulage du verre borosilicaté (45) au moyen du moule en silicium (30') comprend les étapes consistant à :
- mouler une couche de verre borosilicaté ramolli thermiquement (35) sur le moule en silicium (30'), et
- meuler la couche de verre borosilicaté moulée (35) après l'étape de refroidissement et avant l'étape de polissage.

8. Procédé selon la revendication 6, dans lequel l'épaisseur de la couche de verre borosilicaté (35) est supérieure à la distance verticale maximale entre les parties non gravées de la face structurée du moule en silicium (30') et le fond de l'évidement (32) formé par la portion inclinée du moule en silicium (30').

9. Procédé selon la revendication 7, dans lequel l'épaisseur de la couche de verre borosilicaté (35) est comprise entre 200 µm et 1000 µm.

10. Procédé selon l'une quelconque des revendications 1 à 8, dans lequel un angle de couple (α) de la tranche de silicium coupée hors-axe (30) se situe dans une plage comprise entre 5° et 25°, de préférence d'environ 20°, par rapport à l'orientation cristalline Si(111), et l'angle d'inclinaison (β) de la fenêtre optique inclinée est égal à l'angle de coupe (α) de la tranche de silicium coupée hors-axe.

11. Procédé selon l'une quelconque des revendications 1 à 9, dans lequel les plusieurs structures et/ou dispositifs comprennent plusieurs dispositifs MEMS (65).

12. Procédé selon l'une quelconque des revendications 1 à 9, dans lequel les plusieurs structures et/ou dispositifs comprennent plusieurs miroirs MEMS (41), et dans lequel l'angle de couple (α) de la tranche de silicium coupée hors-axe (30) est supérieur à l'angle d'inclinaison maximal (β) du miroir MEMS respectif (41).
